(19)

Europäisches
Patentamt
European
Patent Office
Office européen
des brevets

(11)  **EP 4 135 042 A1**

(12)  # EUROPEAN PATENT APPLICATION
published in accordance with Art. 153(4) EPC

(43) Date of publication:
**15.02.2023  Bulletin 2023/07**

(21) Application number: **20897681.1**

(22) Date of filing: **08.04.2020**

(51) International Patent Classification (IPC):
**H01L 27/32** $^{(2006.01)}$

(52) Cooperative Patent Classification (CPC):
**H01L 27/3276; H01L 27/3248**

(86) International application number:
**PCT/CN2020/083810**

(87) International publication number:
**WO 2021/203320 (14.10.2021 Gazette 2021/41)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(71) Applicants:
• **BOE Technology Group Co., Ltd.**
  **Beijing 100015 (CN)**
• **Chengdu BOE Optoelectronics Technology Co., Ltd.**
  **Chengdu, Sichuan 611731 (CN)**

(72) Inventors:
• **ZHANG, Meng**
  **Beijing 100176 (CN)**
• **HAN, Linhong**
  **Beijing 100176 (CN)**
• **QING, Haigang**
  **Beijing 100176 (CN)**

• **YU, Pengfei**
  **Beijing 100176 (CN)**
• **ZHANG, Xin**
  **Beijing 100176 (CN)**
• **LI, Huijun**
  **Beijing 100176 (CN)**
• **JIANG, Xiaofeng**
  **Beijing 100176 (CN)**
• **YANG, Lulu**
  **Beijing 100176 (CN)**
• **QU, Yi**
  **Beijing 100176 (CN)**
• **BAI, Lu**
  **Beijing 100176 (CN)**
• **DAI, Jie**
  **Beijing 100176 (CN)**

(74) Representative: **Haseltine Lake Kempner LLP**
**Cheapside House**
**138 Cheapside**
**London EC2V 6BJ (GB)**

(54)  **ARRAY SUBSTRATE AND MANUFACTURING METHOD THEREFOR, AND DISPLAY DEVICE**

(57)  array substrate, a method for preparing the same, and a display device. The array substrate includes: abase substrate including a display area and a peripheral area at least on a side of the display area, wherein the peripheral area includes a first trace area and a second trace area; a plurality of sub-pixels in the display area; a plurality of data lines in the display area and electrically connected to the plurality of sub-pixels; and a plurality of data signal transmission lines in the peripheral area and electrically connected to the plurality of data lines, wherein at least one of the data signal transmission lines includes: a first transmission line segment in the first trace area and a second transmission line segment in the second trace area being that are in two different layers and electrically connected to each other; wherein a spacing between two adjacent data lines is greater than a spacing between two adjacent data signal transmission lines. The present disclosure contributes to reduce a resistance difference between different data signal transmission lines, and ensure a good display effect of an array substrate.

**(Cont. next page)**

EP 4 135 042 A1

FIG. 1

## Description

## TECHNICAL FIELD

The present disclosure relates to the technical field of display, and in particular to an array substrate, a method for preparing the same, and a display device.

## BACKGROUND

An array substrate usually includes a display area and a peripheral area surrounding the display area, wherein a sub-pixel array in the display area is arranged in multiple columns, multiple data signal transmission lines in the peripheral area are electrically connected to the multiple columns of sub-pixels in the display area in a one-to-one correspondence to provide data signals for the multiple columns of sub-pixels in the display area, such that the sub-pixels emit light and the array substrate realizes a display function.

## SUMMARY

Embodiments of the present disclosure provide an array substrate, a method for preparing the same, and a display device. Technical solutions of the present disclosure are as follows:

In one aspect, an array substrate is provided. The array substrate includes:

a base substrate including a display area and a peripheral area at least disposed on a side of the display area, wherein the peripheral area includes a first trace area and a second trace area, the second trace area being on a side of the first trace area distal from the display area;
a plurality of sub-pixels in the display area;
a plurality of data lines in the display area, the plurality of data lines being electrically connected to the plurality of sub-pixels; and
a plurality of data signal transmission lines in the peripheral area, the plurality of data signal transmission lines being electrically connected to the plurality of data lines, wherein at least one of the data signal transmission lines includes: a first transmission line segment disposed in the first trace area and a second transmission line segment disposed in the second trace area, the first transmission line segment and the second transmission line segment being in two different layers and electrically connected to each other;
wherein a spacing between two adjacent data lines is greater than a spacing between two adjacent data signal transmission lines.

Optionally, the plurality of data signal transmission lines include a first data signal transmission line and a second data signal transmission line, wherein the first transmission line segment of the first data signal transmission line and the second transmission line segment of the second data signal transmission line are in the same layer.

Optionally, the second transmission line segment of the first data signal transmission line and the first transmission line segment of the second data signal transmission line are in the same layer.

Optionally, at least one of the plurality of sub-pixels includes a thin film transistor and a storage capacitor; wherein

the thin film transistor includes: an active layer on the base substrate, a gate on a side of the active layer distal from the base substrate, a first insulating layer on a side of the gate distal from the base substrate, a second insulating layer on a side of the first insulating layer distal from the base substrate, and a source and a drain on a side of the second insulating layer distal from the base substrate;
the storage capacitor includes a first electrode plate in the same layer as the gate, and a second electrode plate between the first insulating layer and the second insulating layer;
wherein the first transmission line segment of the first data signal transmission line and the second transmission line segment of the second data signal transmission line are in the same layer as the gate, and the second transmission line segment of the first data signal transmission line and the first transmission line segment of the second data signal transmission line are in the same layer as the second electrode plate; or, the second transmission line segment of the first data signal transmission line and the first transmission line segment of the second data signal transmission line are in the same layer as the gate, and the first transmission line segment of the first data signal transmission line and the second transmission line segment of the second data signal transmission line are in the same layer as the second electrode plate.

Optionally, the first data signal transmission line and the second data signal transmission line are disposed alternately with each other.

Optionally, the peripheral area further includes a bending area between the first trace area and the second trace area; and at least one of the data signal transmission lines further includes: a third transmission line segment in the bending area, wherein the third transmission line segment, the first transmission line segment and the second transmission line segment are in three different layers, and the third transmission line segment is electrically connected to the first transmission line segment and the second transmission line segment respectively.

Optionally, the third transmission line segment is electrically connected to the first transmission line segment by a first via, and is electrically connected to the second transmission line segment by a second via.

Optionally, at least one of the plurality of sub-pixels includes a thin film transistor; wherein

the thin film transistor includes: an active layer on the base substrate; a gate on a side of the active layer distal from the base substrate; and a source and a drain on a side of the gate distal from the base substrate; and
the third transmission line segment is in the same layer as the source and the drain.

Optionally, at least one of the plurality of sub-pixels includes a thin film transistor and a connection electrode; wherein

the thin film transistor includes an active layer on the base substrate, a gate on a side of the active layer distal from the base substrate, and a source and a drain on a side of the gate distal from the base substrate; the connection electrode is on a side of the source distal from the base substrate; and
the third transmission line segment and the connection electrode are in the same layer.

Optionally, a resistivity of the third transmission line segment is less than a resistivity of the first transmission line segment; or the resistivity of the third transmission line segment is less than a resistivity of the second transmission line segment.

Optionally, the spacing between two adjacent data signal transmission lines in a range of 0.5 μm to 1.5 μm.

Optionally, the first trace area includes a plurality of sub-trace areas with a gap between two adjacent sub-trace areas.

Optionally, the array substrate further includes a plurality of positive power lines, a positive power bus and a negative power line; the display area includes a first boundary, a second boundary, a third boundary and a fourth boundary; and at least one of the plurality of sub-pixels includes a light-emitting element configured with a first electrode, a light-emitting layer and a second electrode stacked in sequence; wherein

the plurality of positive power lines are in the display area and are electrically connected to the first electrode;
the positive power bus is in the peripheral area, arranged along the first boundary, and electrically connected to the plurality of positive power lines;
the negative power line is in the peripheral area, configured to surround the second boundary, the third boundary and the fourth boundary, and electrically connected to the second electrode; and
a part of the positive power bus and a part of the negative power line are in the gap.

Optionally, the array substrate further includes:

a positive power terminal and a negative power terminal in the peripheral area and on a side of the positive power bus distal from the display area;
wherein the positive power terminal is electrically connected to the positive power bus, and the negative power terminal is electrically connected to the negative power line.

Optionally, the array substrate includes two negative power terminals and three positive power terminals between the two negative power terminals.

Optionally, the array substrate further includes: a circuit board on a side of both the positive power terminal and the negative power terminal distal from the display area, and electrically connected to the positive power terminal, the negative power terminal and the plurality of data signal transmission lines respectively.

Optionally, the circuit board is either a COF or a COP.

Optionally, the light-emitting element is an organic light-emitting diode with the first electrode as an anode thereof and the second electrode as a cathode thereof.

In another aspect, a display device is provided. The display device includes any array substrate as defined in above-mentioned one aspect.

In yet another aspect, a method for preparing an array substrate is provided. The method includes:

providing a base substrate including a display area and a peripheral area at least disposed on a side of the display area, wherein the peripheral area includes a first trace area and a second trace area, the second trace area being on a side of the first trace area distal from the display area; and
forming a plurality of sub-pixels, a plurality of data lines and a plurality of data signal transmission lines on the base substrate; wherein the plurality of sub-pixels and the plurality of data lines are in the display area, the plurality of data lines are electrically connected to the plurality of sub-pixels, the plurality of data signal transmission lines are in the peripheral area and are electrically connected to the plurality of data lines, and at least one of the data signal transmission lines includes: a first transmission line segment disposed in the first trace area and a second transmission line segment disposed in the second trace area, the first transmission line segment and the second transmission line segment being in two different layers and electrically connected to each other;
wherein a spacing between two adjacent data lines is greater than a spacing between two adjacent data signal transmission lines.

## BRIEF DESCRIPTION OF DRAWINGS

In order to illustrate technical solutions in embodiments of the present disclosure more clearly, a brief introduction of the drawings used in the embodiments is provided herein. Obviously, the drawings described below are merely some embodiments of the present disclosure, those skilled in the art may also obtain other drawings according to these drawings without creative work.

FIG. 1 is a front view of an array substrate according to an embodiment of the present disclosure;

FIG. 2 is a front view of another array substrate according to an embodiment of the present disclosure;

FIG. 3 is a sectional view of position a-a, position b-b and position c-c of the array substrate shown in FIG. 1;

FIG. 4 is a sectional view of the position a-a, position d-d and position e-e of the array substrate shown in FIG. 1;

FIG. 5 is another sectional view of the position a-a, the position b-b and the position c-c of the array substrate shown in FIG. 1;

FIG. 6 is another sectional view of the position a-a, the position d-d and the position c-c of the array substrate shown in FIG. 1;

FIG. 7 is a sectional view of position a-a, position b-b and position c-c of the array substrate shown in FIG. 2;

FIG. 8 is a sectional view of the position a-a, position d-d and position e-e of the array substrate shown in FIG. 2;

FIG. 9 is another sectional view of the position a-a, the position b-b and the position c-c of the array substrate shown in FIG. 2;

FIG. 10 is another sectional view of the position a-a, the position d-d and the position c-c of the array substrate shown in FIG. 2;

FIG. 11 is yet another sectional view of the position a-a, the position b-b and the position c-c of the array substrate shown in FIG. 1;

FIG. 12 is still another sectional view of the position a-a, the position b-b and the position c-c of the array substrate shown in FIG. 1;

FIG. 13 is yet another sectional view of the position a-a, the position b-b and the position c-c of the array substrate shown in FIG. 2;

FIG. 14 is still another sectional view of the position a-a, the position b-b and the position c-c of the array substrate shown in FIG. 2;

FIG. 15 is a sectional view of the position a-a, position f-f and position g-g of the array substrates shown in FIG. 1 and FIG. 3;

FIG. 16 is a method flowchart of a method for preparing an array substrate provided by an embodiment of the present disclosure.

## DESCRIPTION OF EMBODIMENTS

Embodiments of the present disclosure are described in further detail with reference to the accompanying drawings, to present the principles, objects, technical solutions and advantages of the present disclosure more clearly.

An active matrix organic light-emitting diode (AMOLED) display device is widely applicable in the field of smart terminal such as mobile phones and tablet computers and the field of flexible wearable device such as smart watches because of advantages of self-luminous capability, wide color gamut, high contrast, lightness and thinness, compared with a traditional liquid crystal display (LCD).

In an AMOLED display device, an array substrate usually includes a display area and a peripheral area surrounding the display area, wherein a sub-pixel array in the display area is arranged in multiple columns, multiple data signal transmission lines in the peripheral area are electrically connected to the multiple columns of sub-pixels in the display area in a one-to-one correspondence to provide data signals for the multiple columns of sub-pixels by a plurality of data lines in the display area, such that the sub-pixels emit light and the array substrate realizes a display function. The sub-pixel includes an organic light emitting diode (OLED) and a driving thin film transistor electrically connected to the OLED for driving the OLED to emit light. A formula of a driving current of the OLED in the operation of the AMOLED display device is as follows:

$$I = K \times (Vsg\text{-}|Vth|)^2 = K \times (VDD\text{-}Vdata\text{-}|Vth|)^2,$$

wherein K represents an intrinsic conductive factor of the driving thin film transistor, Vsg represents a voltage difference between a gate and a source of the driving thin film transistor, Vth represents a threshold voltage of the driving thin film transistor, VDD represents a positive power signal applicable to the source of the driving thin film transistor from a positive power signal line, and Vdata represents a data signal applicable to the gate of the driving thin film transistor form the data line.

It may be known from the formula of the driving current that when the positive power signal VDD has a small change, the driving current of the OLED varies with the data signal Vdata. Since the light-emitting luminance of the OLED is proportional to the driving current, the light-emitting display luminance of the OLED will be affected by the data signal Vdata. In addition, during transmission of the data signal Vdata from a circuit board to the sub-pixels, the data signal Vdata may decrease as the resistance of the data signal transmission line increases, thereby affecting a display effect of the OLED.

At present, in order to reduce the wiring space and compress the screen frame size, each data signal transmission line of an array substrate is disposed in one metal layer, and the plurality of data signal transmission lines are distributed alternatively in two different metal layers one by one. However, due to the influence of preparing processes differences (exposure conditions, different equipment, environmental factors and the like), widths of the data signal transmission lines in the two different metal layers have uncontrollable differences, such that the data signal transmission lines in the two different metal layers have uncontrollable differences of resistance, uncontrollable differences caused by process errors of the resistance between the adjacent data signal transmission lines are caused, the light-emitting luminance of the sub-pixels in different columns has differences, and the display effect is affected.

Embodiments of the present disclosure provide an array substrate, which may be an array substrate in an AMOLED display device. The array substrate includes a plurality of data signal transmission lines electrically connected to columns of sub-pixels by a plurality of data lines. At least one of the data signal transmission lines includes a first transmission line segment and a second transmission line segment disposed in two different layers and electrically connected to each other. In this way, resistances of the first transmission line segment and the second transmission line segment may compensate for each other, such that resistances of different data signal transmission lines have a smaller difference, and hence the light-emitting luminances of sub-pixels in different columns have a smaller difference, which helps to ensure the display effect.

An embodiment of the present disclosure provides an array substrate, including:

a base substrate including a display area and a peripheral area at least disposed on a side of the display area, wherein the peripheral area includes a first trace area and a second trace area disposed on a side of the first trace area distal from the display area; a plurality of sub-pixels disposed in the display area; a plurality of data lines disposed in the display area, the plurality of data lines being electrically connected to the plurality of sub-pixels; and a plurality of data signal transmission lines disposed in the peripheral area and electrically connected to the plurality of data lines, wherein at least one of the data signal transmission lines includes: a first transmission line segment disposed in the first trace area and a second transmission line segment disposed in the second trace area, wherein the first transmission line segment and the second transmission line segment are disposed in two different layers and are electrically connected to each other; wherein a spacing between two adjacent data lines is greater than a spacing between two adjacent data signal transmission lines.

Optionally, the spacing between two adjacent data signal transmission lines is in a range of 0.5 $\mu$m to 1.5 $\mu$m.

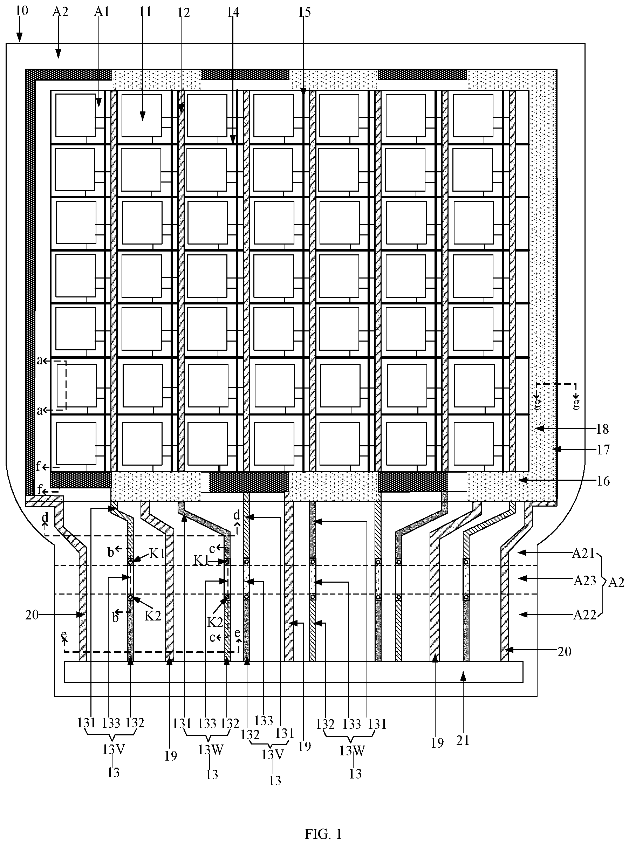

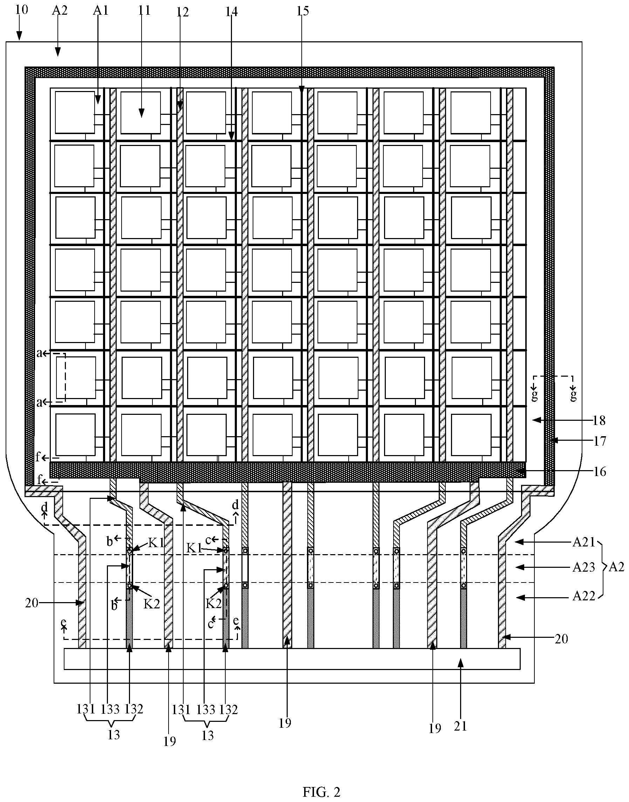

Exemplarily, with reference to FIG. 1 and FIG. 2, FIG. 1 is a front view of an array substrate according to an embodiment of the present disclosure, and FIG. 2 is a front view of another array substrate according to an embodiment of the present disclosure. As shown in FIG. 1 and FIG. 2, an array substrate in embodiments of the present disclosure may include:

a base substrate 10 including a display area A1 and a peripheral area A2 at least disposed on a side of the display area A1, wherein the peripheral area A2 includes a first trace area A21 and a second trace area A22 disposed on a side of the first trace area A21 distal from the display area A1; in embodiments of the present disclosure, as an exemplary configuration for introduction, the peripheral area A2 surrounds the display area A1, and the peripheral area A2 disposed on a side of the display area A1 and including the first trace area A21 and the second trace area A22; a plurality of sub-pixels 11 disposed in the display area A1, wherein the plurality of sub-pixels 11 may emit light, such that the array substrate may realize a display function; a plurality of data lines 12 disposed in the display area A1 and electrically connected to the plurality of sub-pixels 11, wherein the plurality of data lines 12 are configured to make the plurality of sub-pixels 11 emit light by providing data signals to the sub-pixels 11; and a plurality of data signal transmission lines 13 disposed in the peripheral area A2 and electrically connected to the plurality of data lines 12, wherein at least one of the data signal transmission lines 13 includes: a first transmission line segment 131 disposed in the first trace area A21 and a second transmission line segment 132 disposed in the second trace area A22 that are disposed in two different layers and electrically connected to each other; wherein the data signal transmission lines 13 are configured to transmit data signals to the plurality of data lines 12, such that the data lines 12 may provide the data signals to sub-pixels. As shown in FIG. 1 and FIG. 2, in embodiments of the present disclosure, as an exemplary configuration for introduction, the plurality of data signal transmission lines 13 are electrically connected to the plurality of data lines 12 in a one-to-one correspondence, and each of the data signal transmission lines 13 includes the first transmission line segment 131 and the second transmission line segment 132. In practice, the plurality of data signal transmission lines 13 may be one-to-many electrically connected to the plurality of data lines 12 by a multiplexer (MUX), that is, each of the data signal transmission lines 13 may be electrically connected to at least two data lines 12 by a MUX, and a part of the plurality of data signal transmission lines 13 may include the first transmission line segment 131 and the second transmission line segment 132, which is not limited in embodiments of the present disclosure.

A spacing between two adjacent data lines 12 is greater than a spacing between two adjacent data signal transmission lines 13. Optionally, the spacing between two adjacent data signal transmission lines 13 is in a range of 0.5 μm to 1.5 μm. For example, the spacing between two adjacent data signal transmission lines 13 is 0.8 μm, 1.0 μm, or 1.2 μm. The spacing between two adjacent data lines 12 is a distance between the two adjacent data lines 12, and the spacing between two adjacent data signal transmission lines 13 is a distance between the two adjacent data signal transmission lines 13.

In summary, an array substrate provided in embodiments of the present disclosure includes a plurality of data signal transmission lines electrically connected to multiple columns of sub-pixels by a plurality of data lines. At least one of the data signal transmission lines includes a first transmission line segment and a second transmission line segment disposed in two different layers and electrically connected to each other. In this way, resistances of the first transmission line segment and the second transmission line segment may compensate for each other, such that resistances of different data signal transmission lines have a smaller difference, and hence the light-emitting luminances of sub-pixels in different columns have a smaller difference, which helps to ensure the display effect.

Optionally, as shown in FIG. 1 and FIG. 2, the array substrate may further include a plurality of gate lines 14 disposed in the display area A1. A plurality of pixel regions (not marked in FIG. 1 and FIG. 2) are defined by the plurality of gate lines 14 and the plurality of data lines 12 being insulated and intersecting. The plurality of sub-pixels 11 are disposed in the plurality of pixel regions and are electrically connected to the plurality of gate lines 14 and the plurality of data lines 12. The plurality of gate lines 14 are configured to provide gate signals (also called as switching signals) to the plurality of sub-pixels 11, so as to turn on and turn off the plurality of sub-pixels 11. The sub-pixel 11 may receive data signals provided by the data lines 12 when the sub-pixel 11 is turned on, and may not receive data signals provided by the data lines 12 when the sub-pixel 11 is turned off. Exemplarily, the plurality of data lines 12 are parallel to each other, and the plurality of gate lines 14 are parallel to each other, the gate line 14 and the data line 12 are perpendicular to each other, the plurality of pixel regions are arranged in multiple rows and multiple columns, the plurality of sub-pixels 11 are disposed in the plurality of pixel regions in a one-to-one correspondence, each of the gate lines 14 is electrically connected to a row of sub-pixels 11, and each of the data lines 12 is electrically connected to a column of sub-pixels 11.

Optionally, in an embodiment of the present disclosure, at least one of the data signal transmission lines includes: a first transmission line segment disposed in the first trace area and a second transmission line segment disposed in the second trace area that are disposed in two different layers and electrically connected to each other. There may be two possible implementations as follows.

In some embodiments, the plurality of data signal transmission lines include a first data signal transmission line and a second data signal transmission line. The first transmission line segment of the first data signal transmission line and the second transmission line segment of the second data signal transmission line are disposed in the same layer. Optionally, the second transmission line segment of the first data signal transmission line and the first transmission line segment of the second data signal transmission line are disposed in the same layer. Optionally, first data signal transmission lines and second data signal transmission lines are disposed alternately with each other.

Exemplarily, as shown in FIG. 1, the plurality of data signal transmission lines 13 include first data signal transmission lines 13V and second data signal transmission lines 13W disposed alternately with each other. The first transmission line segment 131 of the first data signal transmission line 13V and the second transmission line segment 132 of the second data signal transmission lines 13W are disposed in the same layer, and the second transmission line segment 132 of the first data signal transmission line 13V and the first transmission line segment 131 of the second data signal transmission lines 13W are disposed in the same layer. Those skilled in the art may easily understand that, although an alternative arrangement of the first data signal transmission lines 13V and the second data signal transmission lines 13W one by one in FIG. 1 is taken as an example for illustration, the first data signal transmission lines and the second data signal transmission lines may be arranged alternatively multiple to multiple. For example, multiple first data signal transmission lines and multiple second data signal transmission lines are arranged alternatively, that is, the plurality of data signal transmission lines are arranged alternatively in an arrangement sequence of multiple first data signal transmission lines, multiple second data signal transmission lines, multiple first data signal transmission lines, multiple second data signal transmission lines, and the like, which is not limited in embodiments of the present disclosure.

Optionally, in an embodiment of the present disclosure, at least one of the plurality of sub-pixels includes a thin film transistor and a storage capacitor. The thin film transistor includes an active layer disposed on the base substrate, a gate disposed on a side of the active layer distal from the base substrate, a first insulating layer disposed on a side of the gate distal from the base substrate, a second insulating layer disposed on a side of the first insulating layer distal from the base substrate, and a source and a drain disposed on a side of the second insulating layer distal from the base substrate. The storage capacitor includes a first electrode plate disposed in the same layer as the gate, and a second electrode plate disposed between the first insulating layer and the second insulating layer. The first transmission line segment of the first data signal transmission line and the second transmission line segment of the second data signal transmission line are disposed in the same layer as the gate, and the second transmission line segment of the first data signal transmission line and the first transmission line segment of the second data signal transmission line are disposed in the same layer as the second electrode plate; or, the second transmission line segment of the first data signal transmission line and the first transmission line segment of the second data signal transmission line are disposed in the same layer as the gate, and the first transmission line segment of the first data signal transmission line and the second transmission line segment of the second data signal transmission line are disposed in the same layer as the second electrode plate.

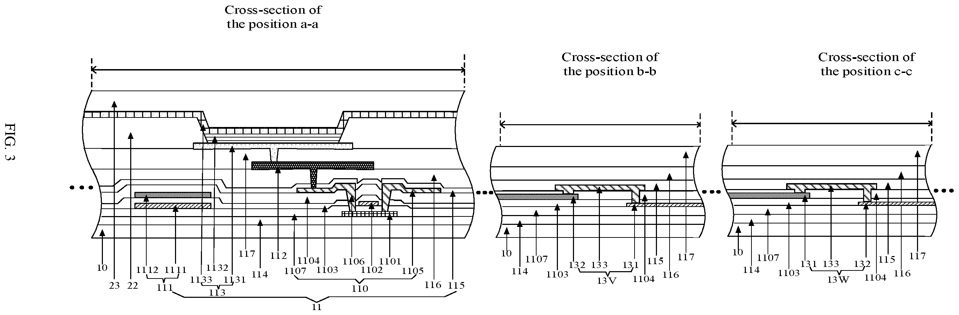

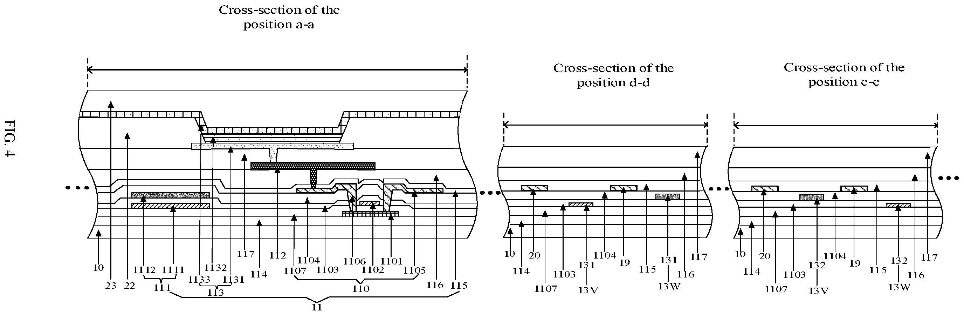

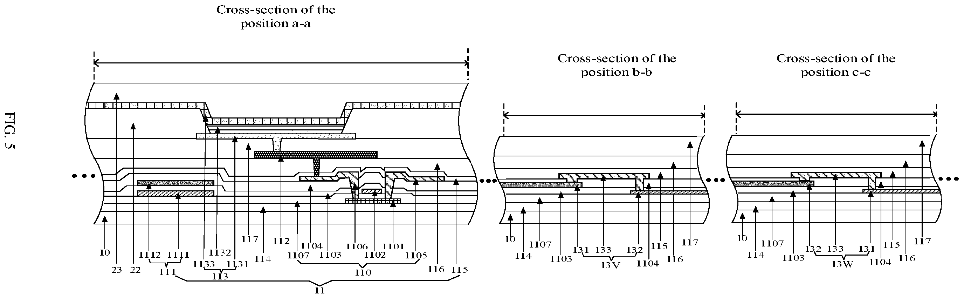

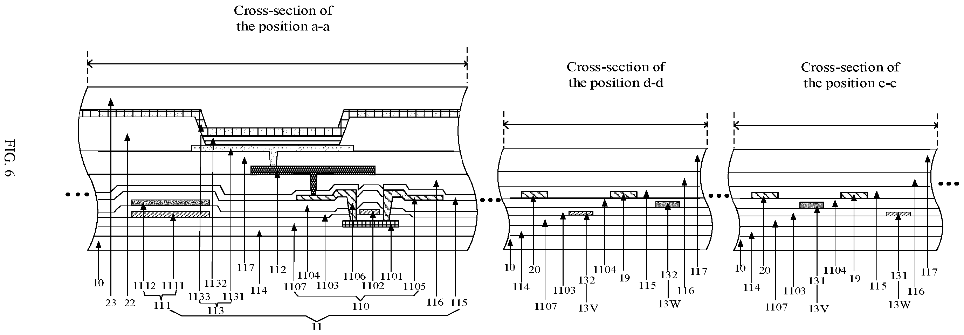

Exemplarily, with reference to FIG. 3 to FIG. 6, FIG. 3 is a sectional view of position a-a, position b-b and position c-c of the array substrate shown in FIG. 1, FIG. 4 is a sectional view of the position a-a, position d-d and position e-e of the array substrate shown in FIG. 1, FIG. 5 is another sectional view of the position a-a, the position b-b and the position c-c of the array substrate shown in FIG. 1, and FIG. 6 is another sectional view of the position a-a, the position d-d and the position c-c of the array substrate shown in FIG. 1. As shown in FIG. 3 to FIG. 6, at least one of the plurality of sub-pixels 11 includes a thin film transistor 110 and a storage capacitor 111. The thin film transistor 110 includes an active layer 1101 disposed on the base substrate 10, a gate 1102 disposed on a side of the active layer 1101 distal from the base substrate 10, a first insulating layer 1103 disposed on a side of the gate 1102 distal from the base substrate 10, a second insulating layer 1104 disposed on a side of the first insulating layer 1103 distal from the base substrate 10, and a source 1105 and a drain 1106 disposed on a side of the second insulating layer 1104 distal from the base substrate 10. The storage capacitor 111 includes a first electrode plate 1111 disposed in the same layer as the gate 1102, and a second electrode plate 1112 disposed between the first insulating layer 1103 and the second insulating layer 1104. As shown in FIG. 3 and FIG. 4, the first transmission line segment 131 of the first data signal transmission line 13V and the second transmission line segment 132 of the second data signal transmission line 13W are disposed in the same layer as the gate 1102, and the second transmission line segment 132 of the first data signal transmission line 13V and the first transmission line segment 131 of the second data signal transmission line 13W are disposed in the same layer as the second electrode plate 1112. Alternatively, as shown in FIG. 5 and FIG. 6, the second transmission line segment 132 of the first data signal transmission line 13V and the first transmission line segment 131 of the second data signal transmission line 13W are disposed in the same layer as the gate 1102, and the first transmission line segment 131 of the first data signal transmission line 13V and the second transmission line segment 132 of the second data signal transmission line 13W are disposed in the same layer as the second electrode plate 1112.

In some other embodiments, the first transmission line segments of the plurality of data signal transmission lines are disposed in the same layer, and the second transmission line segments of the plurality of data signal transmission lines are disposed in the same layer.

Exemplarily, as shown in FIG. 2, the first transmission line segments 131 of the plurality of data signal transmission lines 13 are disposed in the same layer, and the second transmission line segments 132 of the plurality of data signal transmission lines 13 are disposed in the same layer.

Optionally, in an embodiment of the present disclosure, at least one of the plurality of sub-pixels includes a thin film transistor and a storage capacitor. The thin film transistor includes an active layer disposed on the base substrate, a gate disposed on a side of the active layer distal from the base substrate, a first insulating layer disposed on a side of the gate distal from the base substrate, a second insulating layer disposed on a side of the first insulating layer distal from the base substrate, and a source and a drain disposed on a side of the second insulating layer distal from the base substrate. The storage capacitor includes a first electrode plate disposed in the same layer as the gate, and a second electrode plate disposed between the first insulating layer and the second insulating layer. The first transmission line segments of the plurality of data signal transmission lines are disposed in the same layer as the gate, and the second transmission line segments of the plurality of data signal transmission lines are disposed in the same layer as the second electrode plate; or, the second transmission line segments of the plurality of data signal transmission lines are disposed in the same layer as the gate, and the first transmission line segments of the plurality of data signal transmission lines are disposed in the same layer as the second electrode plate.

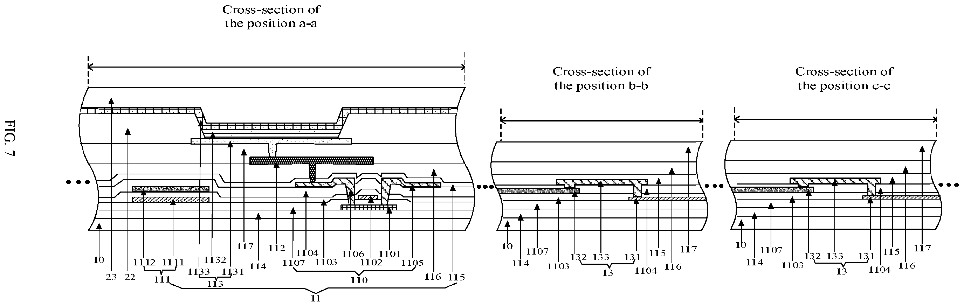

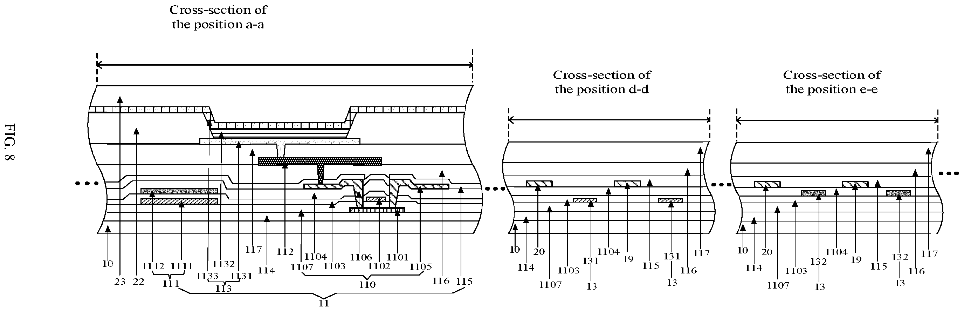

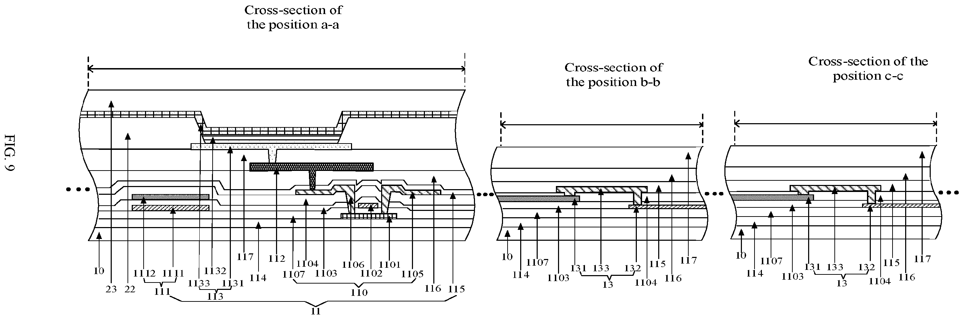

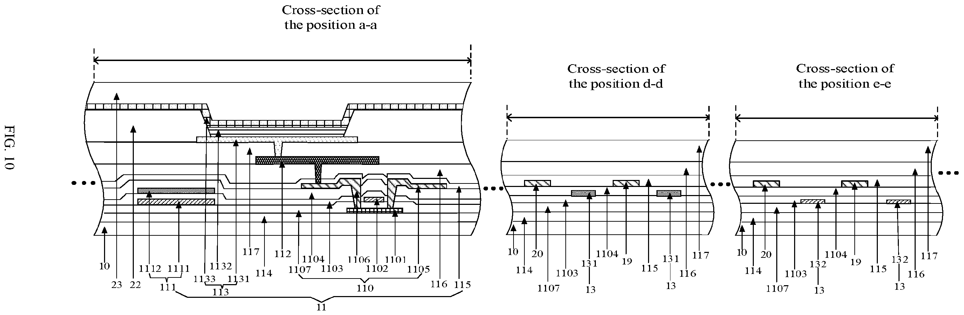

Exemplarily, with reference to FIG. 7 to FIG. 10, FIG. 7 is a sectional view of position a-a, position b-b and position c-c of the array substrate shown in FIG. 2, FIG. 8 is a sectional view of the position a-a, position d-d and position e-e of the array substrate shown in FIG. 2, FIG. 9 is another sectional view of the position a-a, the position b-b and the position c-c of the array substrate shown in FIG. 2, and FIG. 10 is another sectional view of the position a-a, the position d-d and the position c-c of the array substrate shown in FIG. 2. As shown in FIG. 7 and FIG. 10, at least one of the plurality of sub-pixels 11 includes a thin film transistor 110 and a storage capacitor 111. The thin film transistor 110 includes an active layer 1101 disposed on the base substrate 10, a gate 1102 disposed on a side of the active layer 1101 distal from the base substrate 10, a first insulating layer 1103 disposed on a side of the gate 1102 distal from the base substrate 10, a second insulating layer 1104 disposed on a side of the first insulating layer 1103 distal from the base substrate 10, and a source 1105 and a drain 1106 disposed on a side of the second insulating layer 1104 distal from the base substrate 10. The storage capacitor 111 includes a first electrode plate 1111 disposed in the same layer as the gate 1102, and a second electrode plate 1112 disposed between the first insulating layer 1103 and the second insulating layer 1104. As shown in FIG. 7 and FIG. 8, the first transmission line segments 131 of the plurality of data signal transmission lines 13 are disposed in the same layer as the gate 1102, and the second transmission line segments 132 of the plurality of data signal transmission lines 13 are disposed in the same layer as the second electrode plate 1112. Alternatively, as shown in FIG. 9 and FIG. 10, the second transmission line segments 132 of the plurality of data signal transmission line 13 are disposed in the same layer as the gate 1102, and the first transmission line segments 131 of the plurality of data signal transmission line 13 are disposed in the same layer as the second electrode plate 1112.

Optionally, in an embodiment of the present disclosure, the peripheral area further includes a bending area disposed between the first trace area and the second trace area; and at least one of the data signal transmission lines further includes: a third transmission line segment disposed in the bending area, wherein the third transmission line segment, the first transmission line segment and the second transmission line segment are disposed in three different layers, and the third transmission line segment is electrically connected to the first transmission line segment and the second transmission line segment respectively. Optionally, the third transmission line segment is electrically connected to the first transmission line segment by a first via, and is electrically connected to the second transmission line segment by a second via.

Exemplarily, as shown in FIG. 1 and FIG. 2, the peripheral area A2 further includes a bending area A23 disposed between the first trace area A21 and the second trace area A22; and at least one of the data signal transmission lines 13 further includes: a third transmission line segment 133 disposed in the bending area A23, wherein the third transmission line segment 133, the first transmission line segment 131 and the second transmission line segment 132 are disposed in three different layers, and the third transmission line segment 133 is electrically connected to the first transmission line segment 131 and the second transmission line segment 132 respectively, such that the first transmission line segment 131 and the second transmission line segment 132 are electrically connected to each other by the third transmission line segment 133. For example, the third transmission line segment 133 is electrically connected to the first transmission line segment 131 by the first via K1, and is electrically connected to the second transmission line segment 132 by the second via K2. Those skilled in the art may easily understand that, the first via K1 is disposed in and penetrates an insulating layer between the third transmission line segment 133 and the first transmission line segment 131, such that the third transmission line segment 133 is electrically connected to the first transmission line segment 131 by the first via K1; and the second via K2 is disposed in and penetrates an insulating layer between the third transmission line segment 133 and the second transmission line segment 132, such that the third transmission line segment 133 is electrically connected to the second transmission line segment 132 by the second via K2.

Optionally, in an embodiment of the present disclosure, the bending area is respectively adjacent to the first trace area and the second trace area. Optionally, the first trace area includes a first sector-shaped trace area and a first rectangular trace area that are adjacent to each other and are arranged along a direction away from the display area, and the second trace area is a rectangular trace area. Alternatively, the first trace area includes a first sector-shaped trace area and a first rectangular trace area that are adjacent to each other and are arranged along a direction away from the display area, and the second trace area includes a second sector-shaped trace area and a second rectangular trace area that are adjacent to each other and are arranged along a direction away from the display area.

Exemplarily, as shown in FIG. 1 and FIG. 2, the bending area A23 is adjacent to the first trace area A21 and the second trace area A22, that is, the bending area A23 shares a boundary with the first trace area A21 and a boundary with the second trace area A22 respectively. The first trace area A21 includes a first sector-shaped trace area (not marked in FIG. 1 and FIG. 2) and a first rectangular trace area (not marked in FIG. 1 and FIG. 2) that are adjacent to each other and are arranged along a direction away from the display area A1, and the second trace area A22 is a rectangular trace area. Those skilled in the art may easily understand that the second trace area A22 shown in FIG. 1 and FIG. 2 is merely exemplary, and according to the trace requirements of the array substrate, the second trace area A22 may include a second sector-shaped trace area and a second rectangular trace area that are adjacent to each other and are arranged along a direction away from the display area, which is not limited in embodiments of the present disclosure.

Optionally, in an embodiment of the present disclosure, the third transmission line segment, the first transmission line segment and the second transmission line segment are disposed in three different layers, and the third transmission line segment is electrically connected to the first transmission line segment and the second transmission line segment respectively. There may be two possible implementations as follows.

In some embodiments, at least one of the plurality of sub-pixels includes a thin film transistor. The thin film transistor includes an active layer disposed on a base substrate, a gate disposed on a side of the active layer distal from the base substrate, and a source and a drain disposed on a side of the gate distal from the base substrate. The third transmission line segment is disposed in the same layer as the source and the drain.

Exemplarily, as shown in FIG. 3, FIG. 5, FIG. 7, and FIG. 9, at least one of the plurality of sub-pixels 11 includes a thin film transistor 110. The thin film transistor 110 includes an active layer 1101 disposed on a base substrate 10, a gate 1102 disposed on a side of the active layer distal from the base substrate 10, and a source 1105 and a drain 1106 disposed on a side of the gate 1102 distal from the base substrate 10. The third transmission line segment 133 is disposed in the same layer as the source 1105 and the drain 1106. The third transmission line segment 133 is electrically connected to the first transmission line segment 131 by a first via (not marked in FIG. 3, FIG. 5, FIG. 7, and FIG. 9), and is electrically connected to the second transmission line segment 132 by a second via (not marked in FIG. 3, FIG. 5, FIG. 7, and FIG. 9).

In some other embodiments, at least one of the plurality of sub-pixels includes a thin film transistor and a connection electrode. The thin film transistor includes an active layer disposed on a base substrate, a gate disposed on a side of the active layer distal from the base substrate, and a source and a drain disposed on a side of the gate distal from the base substrate. The connection electrode is disposed on a side of the source distal from the base substrate. The third transmission line segment is disposed in the same layer as the connection electrode.

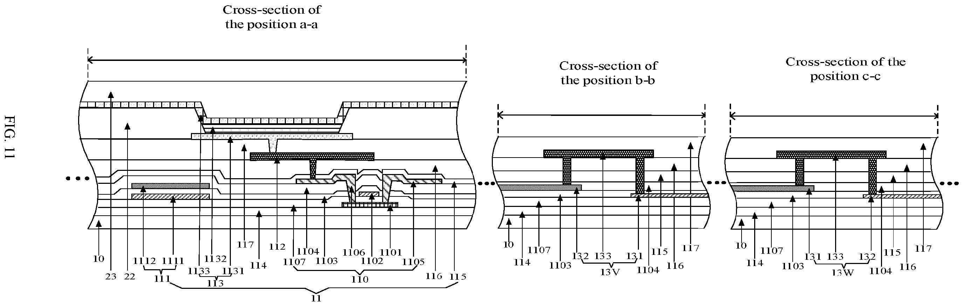

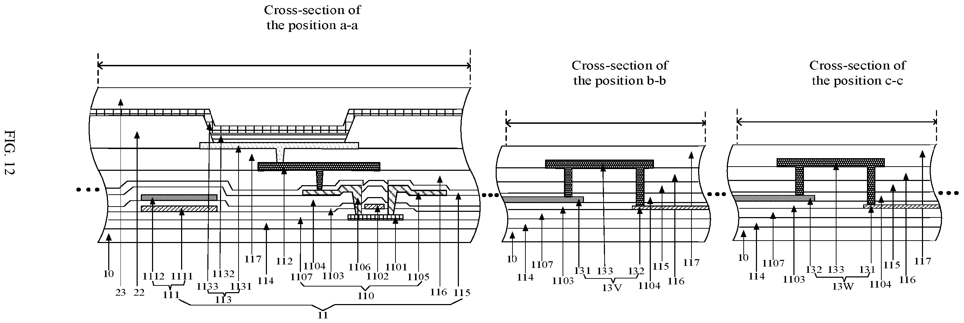

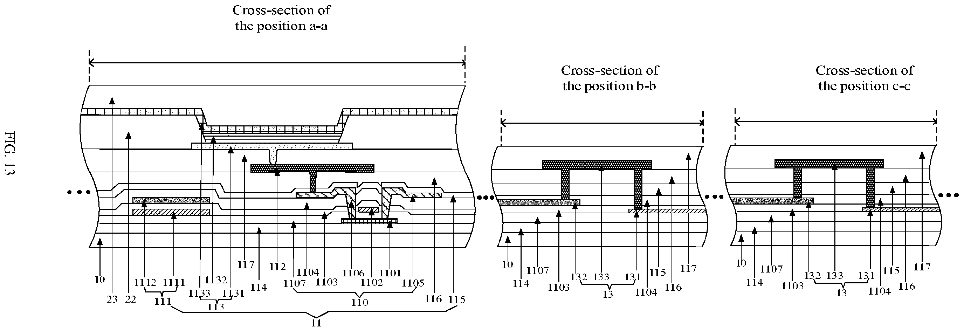

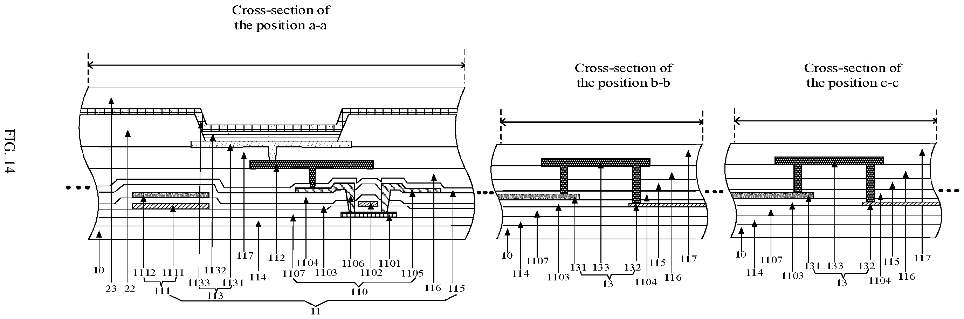

Exemplarily, with reference to FIG. 11 to FIG. 14, FIG. 11 is yet another sectional view of the position a-a, the position b-b and the position c-c of the array substrate shown in FIG. 1, FIG. 12 is still another sectional view of the position a-a, the position b-b and the position c-c of the array substrate shown in FIG. 1, FIG. 13 is yet another sectional view of the position a-a, the position b-b and the position c-c of the array substrate shown in FIG. 2, and FIG. 14 is still another sectional view of the position a-a, the position b-b and the position c-c of the array substrate shown in FIG. 2. As shown in FIGS. 11 to 14, at least one of the plurality of sub-pixels 11 includes a thin film transistor 110 and a connection electrode 112. The thin film transistor 110 includes an active layer 1101 disposed on a base substrate 10, a gate 1102 disposed on a side of the active layer 1101 distal from the base substrate 10, and a source 1105 and a drain 1106 disposed on a side of the gate 1102 distal from the base substrate 10. The connection electrode 112 is disposed on a side of the source 1105 distal from the base substrate 10. The third transmission line segment 133 is disposed in the same layer as the connection electrode 112. The third transmission line segment 133 is electrically connected to the first transmission line segment 131 by a first via (not marked in FIG. 11 to FIG. 14), and is electrically connected to the second transmission line segment 132 by a second via (not marked in FIG. 11 to FIG. 14).

Optionally, in an embodiment of the present disclosure, a resistivity of the third transmission line segment is less than a resistivity of the first transmission line segment; or, the resistivity of the third transmission line segment is less than a resistivity of the second transmission line segment. Exemplarily, a resistivity of the third transmission line segment 133 is less than a resistivity of the first transmission line segment 131; or, the resistivity of the third transmission line segment 133 is less than the resistivity of the second transmission line segment 132; or, the resistivity of the third transmission line segment 133 is less than the resistivity of the first transmission line segment 131 and the resistivity of the second transmission line segment 132. Optionally, the first transmission line segment 131, the second transmission line segment 132 and the third transmission line segment 133 may be in a single-layer structure or a multi-layer structure formed by stacking a plurality of film layers. Exemplarily, the first transmission line segment 131 and the second transmission line segment 132 are in a single-layer structure, and the third transmission line segment 133 is in a multi-layer structure. Exemplarily, the first transmission line segment 131 and the second transmission line segment 132 may be in a single-layer structure formed by Mo; and the third transmission line segment 133 may be in a multi-layer structure formed by Ti and Al, for example, the third transmission line segment 133 may be in a structure stacked by a Ti layer, an Al layer and a Ti layer.

Optionally, in an embodiment of the present disclosure, the first trace area includes a plurality of sub-trace areas with a gap between two adjacent sub-trace areas.

Optionally, in an embodiment of the present disclosure, the array substrate further includes a plurality of positive power lines, a positive power bus and a negative power line; the display area includes a first boundary, a second boundary, a third boundary and a fourth boundary; and at least one of the plurality of sub-pixels includes a light-emitting element configured with a first electrode, a light-emitting layer and a second electrode stacked in sequence,

the plurality of positive power lines are disposed in the display area and are electrically connected to the first electrode;
the positive power bus is disposed in the peripheral area, arranged along the first boundary, and electrically connected to the plurality of positive power lines;
the negative power line is disposed in the peripheral area, configured to surround the second boundary, the third boundary and the fourth boundary, and electrically connected to the second electrode; and
a part of the positive power bus and a part of the negative power line are disposed in the gap.

Exemplarily, as shown in FIG. 1 and FIG. 2, the array substrate further includes: a plurality of positive power lines 15, a positive power bus 16 and a negative power line 17. The positive power line 16 is a VDD signal line, and the negative power line 17 is a VSS signal line. The display area A1 includes a first boundary (not shown in FIG. 1 and FIG. 2), a second boundary (not shown in FIG. 1 and FIG. 2), a third boundary (not shown in FIG. 1 and FIG. 2) and a fourth boundary (not shown in FIG. 1 and FIG. 2). At least one of the plurality of sub-pixels 11 includes a light-emitting element (not shown in FIG. 1 and FIG. 2). The light-emitting element includes a first electrode (not shown in FIG. 1 and FIG. 2), a light-emitting layer (not shown in FIG. 1 and FIG. 2) and a second electrode (not shown in FIG. 1 and FIG. 2) that are stacked in sequence. The plurality of positive power lines 15 are disposed in the display area A1 and are electrically connected to the first electrode; the positive power bus 16 is disposed in the peripheral area A2, arranged along the first boundary of the display area A1, and electrically connected to the plurality of positive power lines 15; the negative power line 17 is disposed in the peripheral area A2, configured to surround the second boundary, the third boundary and the fourth boundary, and electrically connected to the second electrode. Optionally, the array substrate further includes an auxiliary electrode 18 disposed in the peripheral area A2, configured to surround the first boundary, the second boundary, the third boundary and the fourth boundary, and electrically connected to the negative power line 17 and the second electrode 1133 respectively, such that the negative power line 17 is electrically connected to the second electrode 1133 by the auxiliary electrode 18.

The first trace area A21 includes plurality of sub-trace areas (not marked in FIG. 1 and FIG. 2) with a gap (not marked in FIG. 1 and FIG. 2) between two adjacent sub-trace areas, and a part of the positive power bus 16 and a part of the negative power line 17 are disposed in a gap between adjacent sub-trace areas. It should be noted that for the sake of conciseness and clarity of drawings, the gap between adjacent sub-trace areas are not shown in FIG. 1 and FIG. 2. Those skilled in the art may easily understand that, an area where the part of the positive power bus 16 in the first trace area A21 is disposed and an area where the part of the negative power line 17 in the first trace area A21 is disposed are the area where a gap between adjacent sub-trace areas is disposed, such that the position of the gap is the position of the part of the positive power bus 16 in the first trace area A21 and the position of the part of the negative power line 17 in the first trace area A21, which is not limited in embodiments of the present disclosure.

Optionally, the positive power bus includes a first sub-layer of positive power bus and a second sub-layer of positive power bus. The first sub-layer of positive power bus is electrically connected to the second sub-layer of positive power bus. The negative power line includes a first sub-layer of negative power line and a second sub-layer of negative power line. The first sub-layer of negative power line is connected to the second sub-layer of negative power line. The first sub-layer of positive power bus and the first sub-layer of negative power line are disposed in the same layer as the source or the drain, and the second sub-layer of positive power bus and the second sub-layer of negative power line are disposed in the same layer as the connecting electrode.

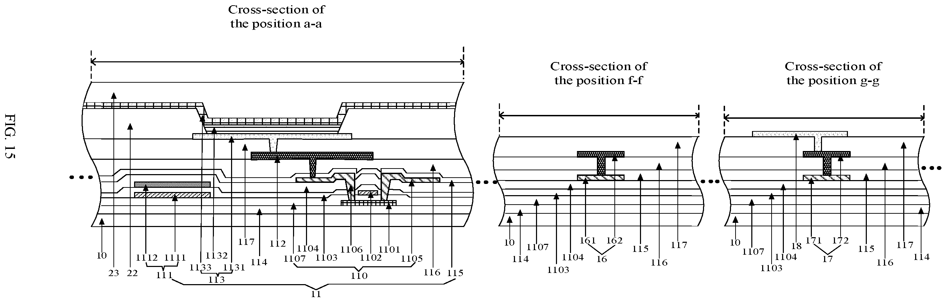

Exemplarily, with reference to FIG. 15, which is a sectional view of the position a-a, position f-f and position g-g of the array substrates shown in FIG. 1 and FIG. 2. As shown in FIG. 15, the positive power bus 16 includes a first sub-layer of positive power bus 161 and a second sub-layer of positive power bus 162. The first sub-layer of positive power bus 161 is electrically connected to the second sub-layer of positive power bus 162. The negative power line 17 includes a first sub-layer of negative power line 171 and a second sub-layer of negative power line 172. The first sub-layer of negative power line 171 is electrically connected to the second sub-layer of negative power line 172. The first sub-layer of positive power bus 161 and the first sub-layer of negative power line 171 are disposed in the same layer as the source 1105 or the drain 1106, and the second sub-layer of positive power bus 162 and the second sub-layer of negative power line 172 are disposed in the same layer as the connection electrode 112. As shown in FIG. 15, the first sub-layer of positive power bus 161 and the second sub-layer of positive power bus 162 are electrically connected by a positive power via (not marked in FIG. 15) which penetrates an insulating layer between the first sub-layer of positive power bus 161 and the second sub-layer of positive power bus 162; and the first sub-layer of negative power line 171 and the second sub-layer of negative power line 172 are electrically connected by a negative power via (not marked in FIG. 15) which penetrates an insulating layer between the first sub-layer of negative power line 171 and the second sub-layer of negative power line 172. Optionally, as shown in FIG. 15, an auxiliary electrode 18 is disposed on a side of the negative power line 17 distal from the base substrate 10 and is electrically connected to the second sub-layer of negative power line 172 by an auxiliary via (not marked in FIG. 15) which penetrates an insulating layer between the auxiliary electrode 18 and the second sub-layer of negative power line 172.

Optionally, the array substrate further includes: a positive power terminal and a negative power terminal disposed in the peripheral area and on a side of the positive power bus distal from the display area. The positive power terminal is electrically connected to the positive power bus, and the negative power terminal is electrically connected to the negative power line.

The positive power terminal is configured to transmit a positive voltage signal to the first electrode of the light-emitting element by the positive power bus and the plurality of positive power lines, and the negative power terminal is configured to transmit a negative voltage signal to the second electrode of the light-emitting element by the negative power line and the auxiliary electrode.

Exemplarily, as shown in FIG. 1 and FIG. 2, the array substrate further includes: a positive power terminal 19 and a negative power terminal 20. The positive power terminal 19 and the negative power terminal 20 are disposed in the peripheral area A2 and on a side of the positive power bus 16 distal from the display area A1. The positive power terminal 19 is electrically connected to the positive power bus 16, and the negative power terminal 20 is electrically connected to the negative power line 17. The positive power terminal 19 is configured to transmit a positive voltage signal to the first electrode of the light-emitting element by the positive power bus 16 and the plurality of positive power lines 15, and the negative power terminal 20 is configured to transmit a negative voltage signal to the second electrode of the light-emitting element by the negative power line 17 and the auxiliary electrode 18. The positive voltage signal may be a VDD signal, the negative voltage signal may be a VSS signal.

Optionally, in an embodiment of the present disclosure, the array substrate includes two negative power terminals and three positive power terminals disposed between the two negative power terminals. Exemplarily, as shown in FIG. 1 and FIG. 2, the array substrate includes two negative power terminals 20 and three positive power terminals 19 disposed between the two negative power terminals 20. The three positive power terminals 19 are configured to transmit positive voltage signals to the first electrode of the light-emitting element by the positive power bus 16 and the plurality of positive power lines 15, and the two negative power terminals 20 are configured to transmit negative voltage signals to the second electrode of the light-emitting element by the negative power line 17 and the auxiliary electrode 18. The two negative power terminals 20 may be symmetrically distributed, and the three positive power terminals 19 may also be symmetrically distributed. Those skilled in the art may easily understand that, the positive power terminals 19 and the negative power terminals 20 shown in FIG. 1 and FIG. 2 are merely exemplary, the number and distribution of positive power terminals and negative power terminals may be configured according to actual requirements and are not limited in embodiments of the present disclosure.

Optionally, the positive power terminal and the negative power terminal are disposed in the same layer as the source or the drain. Exemplarily, as shown in FIG. 4, FIG. 6, FIG. 8 and FIG. 10, the positive power terminal 19 and the negative power terminal 20 are disposed in the same layer as the source 1105 or the drain 1106.

Optionally, the light-emitting element is an organic light-emitting diode with the first electrode as an anode thereof and the second electrode as a cathode thereof.

Optionally, in an embodiment of the present disclosure, the array substrate further includes: a circuit board disposed on a side of both the positive power terminal and the negative power terminal distal from the display area, and electrically connected to the positive power terminal, the negative power terminal and the data signal transmission line respectively.

Exemplarily, as shown in FIG. 1 and FIG. 2, the array substrate further includes: a circuit board 21 disposed on a side of both the positive power terminal 19 and the negative power terminal 20 distal from the display area A1, and electrically connected to the positive power terminal 19, the negative power terminal 20 and the data signal transmission line 13 respectively. As mentioned above, the data signal transmission line 13 may include a first transmission line segment 131, a second transmission line segment 132, and a third transmission line segment 133. In embodiments of the present disclosure, the second transmission line segment 132 of the data signal transmission line 13 may be electrically connected to the circuit board 21. The circuit board 21 may be one of a Chip on Flexible printed circuit board (COF) or a chip on panel (COP). The COF is also referred to as a chip on film. For example, the circuit board 21 may be a COP.

Exemplarily, as shown in FIG. 3 to FIG. 15, at least one of the plurality of sub-pixels 11 includes a thin film transistor 110, a storage capacitor 111, a connection electrode 112 and a light-emitting element 113. The thin film transistor 110 includes an active layer 1101 disposed on the base substrate 10, a third insulating layer 1107 disposed on a side of the active layer 1101 distal from the base substrate 10, a gate 1102 disposed on a side of the third insulating layer 1107 distal from the base substrate 10, a first insulating layer 1103 disposed on a side of the gate 1102 distal from the base substrate 10, a second insulating layer 1104 disposed on a side of the first insulating layer 1103 distal from the base substrate 10, and a source 1105 and a drain 1106 disposed on a side of the second insulating layer 1104 distal from the base substrate 10. The storage capacitor 111 includes a first electrode plate 1111 disposed in the same layer as the gate 1102, and a second electrode plate 1112 disposed between the first insulating layer 1103 and the second insulating layer 1104. The connection electrode 112 is disposed on a side of the thin film transistor 110 distal from the base substrate 10 and electrically connected to the drain 1106. The light-emitting element 113 is disposed on a side of the connection electrode 112 distal from the base substrate 10 and includes the first electrode 1131 electrically connected to the connection electrode 112, the light-emitting layer 1132 and the second electrode 1133 sequentially stacked along a direction distal from the base substrate 10. The third insulating layer 1107 may be a gate insulating layer. The first insulating layer 1103 and the second insulating layer 1104 may be interlayer dielectric layers. The light-emitting element 113 may be an organic light-emitting diode in which the first electrode 1131 may be an anode, the second electrode 1133 may be a cathode, and the light-emitting layer 1132 may be an organic light-emitting layer.

Exemplarily, as shown in FIG. 3 to FIG. 15, at least one of the plurality of sub-pixels 11 further includes a buffer layer 114 disposed between the active layer 1101 and the base substrate 10, a passivation layer 115 and a first flat layer 116 that are disposed between the source 1105 and the connection electrode 112 in a direction away from the base substrate 10, and a second flat layer 117 disposed between the connection electrode 112 and the first electrode 1131. The passivation layer 115 and the first flat layer 116 are provided with connection vias, by which the connection electrode 112 is electrically connected to the drain 1106. The second flat layer 117 is provided with an anode via, by which the first electrode 1131 is electrically connected to the connection electrode112.

Optionally, as shown in FIG. 3 to FIG. 15, the array substrate further includes: a pixel define layer 22 disposed on a side of the second flat layer 117 distal from the base substrate 10 and includes an opening area (not marked in FIG. 3 to FIG. 15), defined by a wall structure, in which the light-emitting element 113 is disposed; and a packaging structure 23 disposed on a side of the light-emitting element 113 distal from the base substrate 10 and configured to encapsulate the light-emitting element 113.

It should be noted that, the third insulating layer 1107, the first insulating layer 1103, the second insulating layer 1104, the buffer layer 114, the passivation layer 115, the first flat layer 116 and the second flat layer 117 in each of the position b-b, the position c-c, the position d-d, the position e-e, the position f-f and the position g-g in FIG. 3 to FIG. 15 may be parts of the third insulating layer 1107, the first insulating layer 1103, the second insulating layer 1104, the buffer layer 114, the passivation layer 115, the first flat layer 116 and the second flat layer 117 in the position a-a extend to the peripheral area A2 respectively. Those skilled in the art may easily understand that, although only the data signal transmission line 13, the positive power bus 16, the negative power bus 17, the auxiliary electrode 18, the positive power terminal 19 and the negative power terminal 20 are shown in each of the position b-b, the position c-c, the position d-d, the position e-e, the position f-f and the position g-g in FIG. 3 to FIG. 15, the peripheral area of the array substrate may further include other circuit structures not shown in FIG. 3 to FIG. 15.

It should also be noted that, in addition to the structure described in the present disclosure, the array substrate may further include other structures. For example, the array substrate may further include an Integrated Circuit (IC), and the like, which is not described in detail in embodiments of the present disclosure.

In summary, an array substrate provided by embodiments of the present disclosure includes a plurality of data signal transmission lines electrically connected to multiple columns of sub-pixels by a plurality of data lines, wherein at least one data signal transmission line includes a first transmission line segment and a second transmission line segment that are disposed in two different layers and electrically connected to each other. In this way, resistances of the first transmission line segment and the second transmission line segment may compensate for each other, such that resistances of different data signal transmission lines have a smaller difference, and hence the light-emitting luminances of sub-pixels in different columns have a smaller difference, which helps to ensure the display effect.

According to the same inventive concept, embodiments of the present disclosure provide a method for preparing an array substrate, which may be applicable to prepare the array substrate provided in the above-mentioned embodiments.

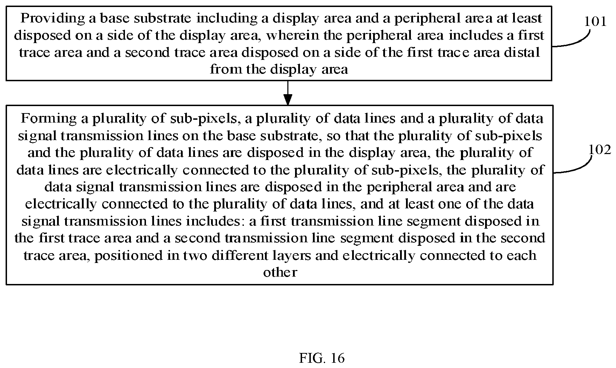

Exemplarily, with reference to FIG. 16, a method flowchart of a method for preparing an array substrate provided by an embodiment of the present disclosure is illustrated. Referring to FIG. 16, the method may include the following steps.

In step 101, a base substrate is provided. The base substrate includes a display area and a peripheral area at least disposed on a side of the display area, wherein the peripheral area includes a first trace area and a second trace area disposed on a side of the first trace area distal from the display area.

In step 102, a plurality of sub-pixels, a plurality of data lines and a plurality of data signal transmission lines are formed on the base substrate. The plurality of sub-pixels and the plurality of data lines are disposed in the display area, the plurality of data lines are electrically connected to the plurality of sub-pixels, the plurality of data signal transmission lines are disposed in the peripheral area and are electrically connected to the plurality of data lines. At least one of the data signal transmission lines includes: a first transmission line segment disposed in the first trace area and a second transmission line segment disposed in the second trace area that are disposed in two different layers and electrically connected to each other.

A spacing between two adjacent data lines is greater than a spacing between two adjacent data signal transmission lines.

In summary, an array substrate, prepared by the method for preparing an array substrate provided by embodiments of the present disclosure, includes a plurality of data signal transmission lines electrically connected to multiple columns of sub-pixels by a plurality of data lines, wherein at least one of the data signal transmission lines includes a first transmission line segment and a second transmission line segment disposed in two different layers and electrically connected to each other. In this way, resistances of the first transmission line segment and the second transmission line segment may compensate for each other, such that resistances of different data signal transmission lines have a smaller difference, and hence the light-emitting luminances of sub-pixels in different columns have a smaller difference, which helps to ensure the display effect.

Exemplarily, in an embodiment of the present disclosure, a method for preparing the array substrate provided in the embodiment shown in FIG. 1 is introduced by taking the layer structures in FIG. 3, FIG. 4, and FIG. 15 as examples. Methods for preparing array substrates with other layer substrate may be acquired by referring the method in the embodiment of the present disclosure which may include the following steps.

In step 201, a base substrate 10 is provided.

As shown in FIG. 1, the base substrate 10 includes a display area A1 and a peripheral area A2 at least disposed on a side of the display area A1. The peripheral area A2 includes a first trace area A21, a second trace area A22 disposed on a side of the first trace area A21 distal from the display area A1, and a bending area A23 disposed between the first trace area A21 and the second trace area A22.

In step 202, a buffer layer 114 is formed on the base substrate 10.

Exemplarily, a material of the buffer layer 114 may be a transparent inorganic material, such as $SiO_x$, $SiN_x$, $Al_2O_3$, or $SiO_xN_x$. Exemplarily, the buffer layer 114 may be formed as a $SiO_x$ material layer by any one of processes such as magnetron sputtering, thermal evaporation, or plasma enhanced chemical vapor deposition (PECVD).

In step 203, an active layer 1101 is formed on a side of the buffer layer 114 distal from the base substrate 10.

Exemplarily, a material of the active layer 1101 may be polysilicon, amorphous silicon or an oxide semiconductor. The oxide semiconductor may be an indium gallium zinc oxide (IGZO) or an indium tin zinc oxide (ITZO) or the like. Exemplarily, an IGZO material layer formed on a side of the buffer layer 114 distal from the base substrate 10 with any one of processes of magnetron sputtering, thermal evaporation, or PECVD, and the active layer 1101 may be obtained by processing the IGZO material layer in one patterning process. The active layer 1101 is disposed in the display area A1.

In step 204, a third insulating layer 1107 is formed on a side of the active layer 1101 distal from the base substrate 10.

The third insulating layer 1107 may be a gate insulating layer. Exemplarily, a material of the third insulating layer 1107 may be a transparent inorganic material, such as $SiO_x$, $SiN_x$, $Al_2O_3$, or $SiO_xN_x$. Exemplarily, a $SiO_x$ material layer formed on a side of the active layer 1101 distal from the base substrate 10 with any one of processes of magnetron sputtering, thermal evaporation, or PECVD, and the third insulating layer 1107 may be obtained by processing the $SiO_x$ material layer in one patterning process.

In step 205, a gate 1102, a first electrode plate 1111, a first transmission line segment 131 of a first data signal transmission line 13V, and a second transmission line segment 132 of a second data signal transmission line 13W are formed on a side of the third insulating layer 1107 distal from the base substrate 10.

Optionally, in step 205, a gate line 14 electrically connected to the gate 1102 may be further formed. The gate line 14, the gate 1102, the first electrode plate 1111, the first transmission line segment 131 of the first data signal transmission line 13V and the second transmission line segment 132 of the second data signal transmission lines 13W are disposed in the same layer. The gate line 14, the gate 1102 and the first electrode plate 1111 are disposed in the display area A1. The first transmission line segment 131 of the first data signal transmission lines 13V and the second transmission line segment 132 of the second data signal transmission line 13W are disposed in the peripheral area A2, the first transmission line segment 131 of the first data signal transmission line 13V is disposed in the first trace area A21, and the second transmission line segment 132 of the second data signal transmission line 13W is disposed in the second trace area A22.

Exemplarily, materials of the gate 1102, the first electrode plate 1111, the gate line 14, the first transmission line segment 131 of the first data signal transmission line 13V, and the second transmission line segment 132 of the second data signal transmission line 13W may be Mo, Cu, Al, Ti, or any alloy thereof. Exemplarily, a Mo material layer is formed on a side of the third insulating layer 1107 distal from the base substrate 10 by any one of processes of magnetron sputtering, thermal evaporation, or PECVD, and the gate line 14, the gate 1102, the first electrode plate 1111, the first transmission line segment 131 of the first data signal transmission line 13V, and the second transmission line segment 132 of the second data signal transmission line 13W may be obtained by processing the Mo material layer in one patterning process.

In step 206, a first insulating layer 1103 is formed on a side of the gate 1102, the first electrode plate 1111, the first transmission line segment 131 of the first data signal transmission line 13V, and the second transmission line segment 132 of the second data signal transmission line 13W distal from the base substrate 10.

The first insulating layer 1103 may be an interlayer dielectric layer. For the preparation process of the first insulating layer 1103, reference may be made to the preparation process of the third insulating layer 1107 in step 204, which is not repeated in the embodiment of the present disclosure.

In step 207, a second plate 1112, a second transmission line segment 132 of the first data signal transmission line 13V, and a first transmission line segment 131 of the second data signal transmission line 13W are formed on a side of the first insulating layer 1103 distal from the base substrate 10.

The second electrode plate 1112, the second transmission line segment 132 of the first data signal transmission line 13V, and the first transmission line segment 131 of the second data signal transmission line 13W are disposed in the same layer. The second electrode plate 1112 is disposed in the display area A1 and opposite to the first electrode plate 1111. The storage capacitor 111 is constituted by the first electrode plate 1111 and the second electrode plate 1112. The second transmission line segment 132 of the first data signal transmission line 13V and the first transmission line segment 131 of the second data signal transmission line 13W are disposed in the peripheral area A2. The second transmission line segment 132 of the first data signal transmission line 13V is disposed in the second trace area A22, and the first transmission line segment 131 of the second data signal transmission line 13W is disposed in the first trace area A21.

Exemplarily, materials of the second electrode plate 1112, the second transmission line segment 132 of the first data signal transmission line 13V, and the first transmission line segment 131 of the second data signal transmission line 13W may be Mo, Cu, Al, Ti, or any alloy thereof. Exemplarily, a Mo material layer is formed on a side of the first insulating layer 1103 distal from the base substrate 10 by any one of processes of magnetron sputtering, thermal evaporation, or PECVD, and the second electrode plate 1112, the second transmission line segment 132 of the first data signal transmission line 13V, and the first transmission line segment 131 of the second data signal transmission line 13W may be obtained by processing the Mo material layer in one patterning process,.

In step 208, a second insulating layer 1104 is formed on a side of the second electrode plate 1112, the second transmission line segment 132 of the first data signal transmission line 13V, and the first transmission line segment 131 of the second data signal transmission line 13W distal from the base substrate 10.

The second insulating layer 1104 may be an interlayer dielectric layer. For the preparation process of the second insulating layer 1104, reference may be made to the preparation process of the third insulating layer 1107 in step 204, which is not repeated in the embodiment of the present disclosure.

In step 209, a source 1105, a drain 1106, a third transmission line segment 133, a first sub-layer of positive power bus 161, a first sub-layer of negative power line 171, a positive power terminal 19 and a negative power terminal 20 are formed on a side of the second insulating layer 1104 distal from the base substrate 10.

Optionally, in step 209, a data line 12 electrically connected to the source 1105 may further be formed. The data line 12, the source 1105, the drain 1106, the third transmission line segment 133 of the data signal transmission line 13, the first sub-layer of positive power bus 161, the first sub-layer of negative power line 171, the positive power terminal 19 and the negative power terminal 20 are disposed in the same layer. The data line 12, the source 1105 and the drain 1106 are disposed in the display area A1. The data line 12 and the gate line 14 define a pixel region by intersecting in the display area A1. The active layer 1101, the gate 1102, the source 1105 and the drain 1106 are disposed in the pixel region. A thin film transistor 110 is constituted by: portions, located in the pixel region, of the active layer 1101, the gate 1102, the source 1105, the drain 1106 and the first insulating layer 1103; a portion, located in the pixel region, of the second insulating layer 1104; and a portion, located in the pixel region, of the third insulating layer 1107. The third transmission line segment 133 of the data signal transmission line 13, the first sub-layer of positive power bus 161, the first sub-layer of negative power line 171, the positive power terminal 19 and the negative power terminal 20 are disposed in the peripheral region A2, and the third transmission line segment 133 of the data signal transmission line 13 is disposed in the bending area A23. The third transmission line segment 133 is electrically connected to the first transmission line segment 131 by a first via and is electrically connected to the second transmission line segment 132 by a second via. The third transmission line segment 133 in step 209 includes a third transmission line segment 133 of the first data signal transmission line 13V and a third transmission line segment 133 of the second data signal transmission lines 13W.

Exemplarily, each of the data line 12, the source 1105, the drain 1106, the third transmission line segment 133, the first sub-layer of positive power bus 161, the first sub-layer of negative power line 171, the positive power terminal 19 and the negative power terminal 20 may be in a single-layer structure or in a multi-layer structure. Materials of the data line 12, the source 1105, drain 1106, the third transmission line segment 133, the first sub-layer of positive power bus 161, the first sub-layer of negative power line 171, the positive power terminal 19 and the negative power terminal 20 may be Mo, Cu, Al, Ti, or any alloy thereof.

Exemplarily, taking each of the data line 12, the source 1105, the drain 1106, the third transmission line segment 133, the first sub-layer of positive power bus 161, the first sub-layer of negative power line 171, the positive power terminal 19 and the negative power terminal 20 being in a multi-layer structure as an example, a Ti material layer, an Al material layer and a Ti material layer that are stacked in sequence are formed on a side of the second insulating layer 1104 distal from the base substrate 10 by any one of processes of magnetron sputtering, thermal evaporation, or PECVD, and the data line 12, the source 1105, the drain 1106, the third transmission line segment 133, the first sub-layer of positive power bus 161, the first sub-layer of negative power line 171, the positive power terminal 19 and the negative power terminal 20 may be obtained by processing the Ti material layer, the Al material layer and the Ti material layer that are stacked in sequence in one patterning process.

In step 210, a passivation layer 115 is formed on a side of the source 1105, the drain 1106, the third transmission line segment 133, the first sub-layer of positive power bus 161, the first sub-layer of negative power line 171, the positive power terminal 19 and the negative power terminal 20 distal from the base substrate 10.

Exemplarily, a material of the passivation layer 115 may be a transparent inorganic material, such as $SiO_x$, $SiN_x$, $Al_2O_3$, or $SiO_xN_x$. Exemplarily, a $SiO_x$ material layer is formed on a side of the data line 12, the source 1105, the drain 1106, the third transmission line segment 133, the first sub-layer of positive power bus 161, the first sub-layer of negative power line 171, the positive power terminal 19 and the negative power terminal 20 distal from the base substrate 10 by any one of processes of magnetron sputtering, thermal evaporation, or PECVD, and the passivation layer 115 may be obtained by processing the $SiO_x$ material layer in one patterning process.

In step 211, a first flat layer 116 is formed on a side of the passivation layer 115 distal from the base substrate 10.

Exemplarily, a material of the first flat layer 116 may be a transparent organic material such as organic resin or a transparent inorganic material such as $SiO_x$, $SiN_x$, $Al_2O_3$, or $SiO_xN_x$. Exemplarily, an organic resin material layer is formed on a side of the passivation layer 115 distal from the base substrate 10 by any one of processes of magnetron sputtering, thermal evaporation, or PECVD, and the first flat layer 116 may be obtained by processing the organic resin material layer in one patterning process.

In step 212, a connection electrode 112, a second sub-layer of positive power bus 162 and a second sub-layer of negative power line 172 are formed on a side of the first flat layer 116 distal from the base substrate 10.

The connection electrode 112, the second sub-layer of positive power bus 162 and the second sub-layer of negative power line 172 are disposed in the same layer. The connection electrode 112 is disposed in the display area A1 and is connected to the drain 1106 of the thin film transistor 110 by a connection via. The second sub-layer of positive power bus 162 and the second sub-layer of negative power line 172 are disposed in the peripheral area A2. The second sub-layer of positive power bus 162 and the first sub-layer of positive power bus 161 constitute a positive power bus 16 by electrically connecting to each other by a positive power via, and the second sub-layer of negative power line 172 and the first sub-layer of negative power line 171 constitute a negative power line 17 by electrically connecting to each other by a negative power via. The positive power bus 16 is arranged along the first boundary of the display area A1, and the negative power line 17 is configured to surround the second boundary, the third boundary and the fourth boundary of the display area A1.

Exemplarily, materials of the connection electrode 112, the second sub-layer of positive power bus 162 and the second sub-layer of negative power line 172 may be Mo, Cu, Al, Ti, or alloy thereof. An Al material layer is formed on a side of the first flat layer 116 distal from the base substrate 10 by any one of processes of magnetron sputtering, thermal evaporation, or PECVD, and the connection electrode 112, the second sub-layer of positive power bus 162 and the second sub-layer of negative power line 172 may be obtained by processing the Al material layer in one patterning process.

In step 213, a second flat layer 117 is formed on a side of the connection electrode 112, the second sub-layer of positive power bus 162 and the second sub-layer of negative power line 172 distal from the base substrate 10.

For the preparation process of the second flat layer 117, reference may be made to the preparation process of the first flat layer 116 in step 211, which is not repeated in the embodiment of the present disclosure.

In step 214, a first electrode 1131 and an auxiliary electrode 18 are formed on a side of the second flat layer 117 distal from the base substrate 10.

The first electrode 1131 and the auxiliary electrode 18 are disposed in the same layer. The first electrode 1131 is disposed in the display area A1 and is electrically connected to the connection electrode 112. The auxiliary electrode 18 is disposed in the peripheral area A2, configured to surround the first boundary, the second boundary, the third boundary and the fourth boundary of the display area A1, and electrically connected to the negative power line 17. For example, the auxiliary electrode 18 is electrically connected to the second sub-layer of negative power line 172 by an auxiliary via.

Exemplarily, materials of both the first electrode 1131 and the auxiliary electrode 18 may be metal oxides, such as indium tin oxide (ITO), indium zinc oxide (IZO) or aluminum doped zinc oxide (ZnO:Al) and the like. Exemplarily, an ITO material layer is formed on a side of the second flat layer 117 distal from the base substrate 10 by any one of processes of magnetron sputtering, thermal evaporation, or PECVD, and the first electrode 1131 may be obtained by processing the ITO material layer in one patterning process.

In step 215, a pixel define layer 22 including an opening area defined by a wall structure is formed on a side of both the first electrode 1131 and the auxiliary electrode 18 distal from the base substrate 10.

As shown in FIG. 3, FIG. 4, and FIG. 15, the first electrode 1131 is at least partially disposed in the opening area defined by the wall structure.

Exemplarily, a material of the pixel define layer 22 may be a transparent organic material such as organic resin or transparent inorganic materials such as SiOx, SiNx, $Al_2O_3$, or SiOxNx. Exemplarily, an organic resin material layer is formed on a side of the first electrode 1131 and the auxiliary electrode 18 distal from the base substrate 10 by any one of processes of magnetron sputtering, thermal evaporation, or PECVD, and the pixel define layer 22 may be obtained by processing the organic resin material layer in one patterning process.

In step 216, a light-emitting layer 1132 is formed in the opening area of the pixel define layer 22.

The light-emitting layer 1132 may be an organic light-emitting layer. Exemplarily, the light-emitting layer 1132 may be obtained by drying an organic light-emitting material solution printed in the opening area of the pixel define layer 22 by an inkjet printing process.

In step 217, a second electrode 1133 is formed on a side of the light-emitting layer 1132 distal from the base substrate 10.

The second electrode 1133 is electrically connected to the auxiliary electrode 18. A light-emitting element 113 is constituted by portions, disposed in the opening area of the pixel define layer 22 and stacked on each other, of the first electrode 1131, the light-emitting layer 1132 and the second electrode 1133. A sub-pixel 11 is constituted by: portions, disposed in the pixel region, of the thin film transistor 110, the storage capacitor 111, the connection electrode 112, the light-emitting element 113 and the buffer layer 114; a portion, disposed in the pixel region, of the passivation layer 115; a portion, disposed in the pixel region, of the first flat layer 116; and a portion, disposed in the pixel region, of the second flat layer 117.

Exemplarily, a material of the second electrode 1133 may be Mo, Cu, Al, Ti, or any alloy thereof. An Al material layer is formed on a side of the light-emitting layer 1132 distal from the base substrate 10 by any one of processes of magnetron sputtering, thermal evaporation, or PECVD, and the second electrode 1133 may be obtained by processing the Al material layer in one patterning process.

In step 218, a packaging structure 23 is formed on a side of the second electrode 1133 distal from the base substrate 10.

The packaging structure 23 is configured to encapsulate the light-emitting element 113. The packaging structure 23 may be a flexible packaging structure which may include an inorganic layer and an organic layer alternately stacked. Exemplarily, the packaging structure 23 may be obtained by forming alternately stacked inorganic layers and organic layers on a side of the second electrode 1133 distal from the base substrate 10.

It should be noted that, in the method for preparing an array substrate provided by embodiments of the present disclosure, one patterning process involved may include steps of photoresist coating, exposure, development, etching and photoresist stripping; and the processing on a material layer (such as an ITO material layer) by one patterning process may include steps of: forming a photoresist layer by coating a layer of photoresist on the material layer (such as an ITO material layer); forming a fully exposed area and a non-exposed area on the photoresist layer by exposing the photoresist layer with a mask; removing the photoresist in the fully exposed area and retaining all the photoresist in the non-exposed area with a development process; etching an area on the material layer (such as an ITO material layer) corresponding to the fully exposed area with an etching process; and finally obtaining a corresponding structure (for example, the first electrode 1131) by stripping the photoresist in the non-exposed area. Those skilled in the art may easily understand that, the photoresist in the above description is a positive photoresist as an example. When a negative photoresist is employed, a procedure of one patterning process may be performed by referring to the above description and is not described in detail in embodiments of the present disclosure.

In summary, an array substrate, prepared by the method for preparing an array substrate provided by embodiments of the present disclosure, includes a plurality of data signal transmission lines electrically connected to multiple columns of sub-pixels by a plurality of data lines. At least one of the data signal transmission lines includes a first transmission line segment and a second transmission line segment that are disposed in two different layers and electrically connected to each other. In this way, resistances of the first transmission line segment and the second transmission line segment may compensate for each other, such that resistances of different data signal transmission lines have a smaller difference, and hence the light-emitting luminances of sub-pixels in different columns have a smaller difference, which helps to ensure the display effect.

According to the same inventive concept as above-mentioned embodiments, embodiments of the present disclosure further provide a display device. The display device includes any one of the above-mentioned array substrates. The display device may be any product or component with a display function, such as a mobile phone, a tablet computer, a television, a display, a notebook computer, a digital photo frame, a navigator, or a wearable device.

In embodiments of the present disclosure, the term "same layer" refers to the relationship between layers simultaneously formed in the same step. For example, in an example, the first transmission line segment 131 and the gate 1102 are disposed in the same layer when they are formed as a result of one or more steps of the same patterning process performed on the same material layer; in another example, the first transmission line segment 131 and the gate 1102 may be formed in the same layer by simultaneously performing a step of forming the first transmission line segment 131 and a step of forming the gate 1102; the term "the same layer" does not always mean that the layer thickness or the layer height in a cross-sectional view is the same.

In embodiments of the present disclosure, the terms "first", "second", "third", and the like do not denote any order, quantity, or importance, but are merely used to distinguish different components. The term "electrically connected" refers to a direct or indirect electrical connection between two conductors, and the two conductors may transmit electrical signals, while there is not necessarily an electrical signal transmission between the two conductors. The term "at least one" refers to one or more, and "a plurality of" refers to two or more.

It should be noted that in the accompanying drawings, for clarity of the illustration, the dimension of partial layers or all of layers or partial regions or all of regions may be scaled up. It may be understood that when an element or layer is described as being "above" another element or layer, the described element or layer may be directly on the other element or layer, or at least one intermediate element or layer may be arranged between the described element or layer and the other element or layer. In addition, it may be understood that when an element or layer is described as being "below" another element or layer, the described element or layer may be directly below the other element or layer, or at least one intermediate element or layer may be arranged between the described element or layer and the other element or layer. In addition, it may be further understood that when a layer or element is described as being arranged "between" two layers or elements, the described layer or element may be the only layer between the two layers or elements, or at least one intermediate layer or element may be arranged between the described element or layer and the two layers or elements. In the whole specification described above, like reference numerals denote like elements.

Described above are merely some exemplary embodiments of the present disclosure, which are not intended to limit the present disclosure. Any modifications, equivalent replacements and improvements made within the spirits and principles of the present disclosure shall all fall in the protection scope of the present disclosure.

**Claims**

1. An array substrate, comprising:

   a base substrate comprising a display area and a peripheral area at least on a side of the display area, wherein the peripheral area comprises a first trace area and a second trace area, the second trace area being on a side of the first trace area distal from the display area;
   a plurality of sub-pixels in the display area;
   a plurality of data lines in the display area, the plurality of data lines being electrically connected to the plurality of sub-pixels; and
   a plurality of data signal transmission lines in the peripheral area, the plurality of data signal transmission lines being electrically connected to the plurality of data lines, wherein at least one of the data signal transmission lines comprises: a first transmission line segment in the first trace area and a second transmission line segment in the second trace area, the first transmission line segment and the second transmission line segment being in different layers and electrically connected to each other;
   wherein a spacing between two adjacent data lines is greater than a spacing between two adjacent data signal transmission lines.

2. The array substrate according to claim 1, wherein the plurality of data signal transmission lines comprise a first data signal transmission line and a second data signal transmission line, wherein the first transmission line segment of the first data signal transmission line and the second transmission line segment of the second data signal transmission line are in the same layer.

3. The array substrate according to claim 2, wherein the second transmission line segment of the first data signal transmission line and the first transmission line segment of the second data signal transmission line are in the same layer.

4. The array substrate according to claim 3, wherein

   at least one of the plurality of sub-pixels comprises a thin film transistor and a storage capacitor;
   wherein the thin film transistor comprises an active layer on the base substrate, a gate on a side of the active layer distal from the base substrate, a first insulating layer on a side of the gate distal from the base substrate, a second insulating layer on a side of the first insulating layer distal from the base substrate, and a source and a drain on a side of the second insulating layer distal from the base substrate; and
   the storage capacitor comprises a first electrode plate in the same layer as the gate, and a second electrode plate between the first insulating layer and the second insulating layer;
   wherein the first transmission line segment of the first data signal transmission line and the second transmission line segment of the second data signal transmission line are in the same layer as the gate, and the second transmission line segment of the first data signal transmission line and the first transmission line segment of the second data signal transmission line are in the same layer as the second electrode plate; or
   the second transmission line segment of the first data signal transmission line and the first transmission line segment of the second data signal transmission line are in the same layer as the gate, and the first transmission line segment of the first data signal transmission line and the second transmission line segment of the second data signal transmission line are in the same layer as the second electrode plate.

5. The array substrate according to any one of claims 2 to 4, wherein the first data signal transmission line and the second data signal transmission line are disposed alternately with each other.

**6.** The array substrate according to any one of claims 1 to 5, wherein

the peripheral area further comprises a bending area between the first trace area and the second trace area; and

at least one of the data signal transmission lines further comprises: a third transmission line segment in the bending area, wherein the third transmission line segment, the first transmission line segment and the second transmission line segment are in three different layers, and the third transmission line segment is electrically connected to the first transmission line segment and the second transmission line segment respectively.

**7.** The array substrate according to claim 6, wherein the third transmission line segment is electrically connected to the first transmission line segment by a first via, and is electrically connected to the second transmission line segment by a second via.

**8.** The array substrate according to claim 6 or 7, wherein

at least one of the plurality of sub-pixels comprises a thin film transistor; wherein

the thin film transistor comprises an active layer on the base substrate, a gate on a side of the active layer distal from the base substrate, and a source and a drain on a side of the gate distal from the base substrate; and

the third transmission line segment is in the same layer as the source and the drain.

**9.** The array substrate according to claim 6 or 7, wherein

at least one of the plurality of sub-pixels comprises a thin film transistor and a connection electrode; wherein

the thin film transistor comprises an active layer on the base substrate, a gate on a side of the active layer distal from the base substrate, and a source and a drain on a side of the gate distal from the base substrate;

the connection electrode is on a side of the source distal from the base substrate; and

the third transmission line segment and the connection electrode are in the same layer.

**10.** The array substrate according to any one of claims 6 to 9, wherein

a resistivity of the third transmission line segment is less than a resistivity of the first transmission line segment; or

the resistivity of the third transmission line segment is less than a resistivity of the second transmission line segment.

**11.** The array substrate according to any one of claims 1 to 10, wherein the spacing between two adjacent data signal transmission lines is in a range of 0.5 $\mu$m to 1.5 $\mu$m.

**12.** The array substrate according to any one of claims 1 to 11, wherein the first trace area comprises a plurality of sub-trace areas with a gap between two adjacent sub-trace areas.

**13.** The array substrate according to claim 12, wherein

the array substrate further comprises a plurality of positive power lines, a positive power bus and a negative power line; the display area comprises a first boundary, a second boundary, a third boundary and a fourth boundary; and at least one of the plurality of sub-pixels comprises a light-emitting element configured with a first electrode, a light-emitting layer and a second electrode stacked in sequence; wherein

the plurality of positive power lines are in the display area and are electrically connected to the first electrode;

the positive power bus is in the peripheral area, arranged along the first boundary, and electrically connected to the plurality of positive power lines;

the negative power line is in the peripheral area, configured to surround the second boundary, the third boundary and the fourth boundary, and electrically connected to the second electrode; and

a part of the positive power bus and a part of the negative power line are in the gap.

**14.** The array substrate according to claim 13, wherein the array substrate further comprises:

a positive power terminal and a negative power terminal in the peripheral area and on a side of the positive power bus distal from the display area;

wherein the positive power terminal is electrically connected to the positive power bus, and the negative power terminal is electrically connected to the negative power line.

**15.** The array substrate according to claim 14, wherein the array substrate comprises two negative power terminals and three positive power terminals between the two negative power terminals.

**16.** The array substrate according to claim 14 or 15, wherein the array substrate further comprises:
a circuit board on a side of both the positive power terminal and the negative power terminal distal from the display area, and electrically connected to the positive power terminal, the negative power terminal and the plurality of data signal transmission lines respectively.

17. The array substrate according to claim 16, wherein the circuit board is either a COF or a COP.

18. The array substrate according to any one of claims 13 to 17, wherein the light-emitting element is an organic light-emitting diode with the first electrode as an anode thereof and the second electrode as a cathode thereof.

19. A display device comprising the array substrate as defined in any one of claims 1 to 18.

20. A method for preparing an array substrate, comprising:

Providing a base substrate comprising a display area and a peripheral area at least on a side of the display area, wherein the peripheral area comprises a first trace area and a second trace area, the second trace area being on a side of the first trace area distal from the display area; and
forming a plurality of sub-pixels, a plurality of data lines and a plurality of data signal transmission lines on the base substrate; wherein the plurality of sub-pixels and the plurality of data lines are in the display area, the plurality of data lines are electrically connected to the plurality of sub-pixels, the plurality of data signal transmission lines are in the peripheral area and are electrically connected to the plurality of data lines, and at least one of the data signal transmission lines comprises: a first transmission line segment in the first trace area and a second transmission line segment in the second trace area, the first transmission line segment and the second transmission line segment being in two different layers and electrically connected to each other;
wherein a spacing between two adjacent data lines is greater than a spacing between two adjacent data signal transmission lines.

FIG. 1

FIG. 2

Cross-section of
the position c-c

Cross-section of
the position b-b

Cross-section of
the position a-a

FIG. 3

Cross-section of the
position a-a

Cross-section of the
position d-d

Cross-section of the
position e-e

FIG. 4

EP 4 135 042 A1

FIG. 5

Cross-section of
the position e-e

Cross-section of
the position d-d

Cross-section of
the position a-a

FIG. 6

FIG. 7

FIG. 8

Cross-section of the
position c-c

Cross-section of
the position b-b

Cross-section of
the position a-a

FIG. 9

FIG. 10

FIG. 11

EP 4 135 042 A1

FIG. 12

32

FIG. 13

FIG. 14

FIG. 15

| Providing a base substrate including a display area and a peripheral area at least disposed on a side of the display area, wherein the peripheral area includes a first trace area and a second trace area disposed on a side of the first trace area distal from the display area | 101 |

| Forming a plurality of sub-pixels, a plurality of data lines and a plurality of data signal transmission lines on the base substrate, so that the plurality of sub-pixels and the plurality of data lines are disposed in the display area, the plurality of data lines are electrically connected to the plurality of sub-pixels, the plurality of data signal transmission lines are disposed in the peripheral area and are electrically connected to the plurality of data lines, and at least one of the data signal transmission lines includes: a first transmission line segment disposed in the first trace area and a second transmission line segment disposed in the second trace area, positioned in two different layers and electrically connected to each other | 102 |

FIG. 16

<table>
<tr><td colspan="2" align="center">**INTERNATIONAL SEARCH REPORT**</td><td>International application No.<br>**PCT/CN2020/083810**</td></tr>
</table>

**A.    CLASSIFICATION OF SUBJECT MATTER**

H01L 27/32(2006.01)i

According to International Patent Classification (IPC) or to both national classification and IPC

**B.    FIELDS SEARCHED**

Minimum documentation searched (classification system followed by classification symbols)

H01L

Documentation searched other than minimum documentation to the extent that such documents are included in the fields searched

Electronic data base consulted during the international search (name of data base and, where practicable, search terms used)

CNPAT, CNKI, WPI, EPODOC: 显示, 数据, 传输, 延伸, 信号, 不同, 层, 异层, display, data, transfer, extension, signal, different +, layer

**C.    DOCUMENTS CONSIDERED TO BE RELEVANT**

| Category* | Citation of document, with indication, where appropriate, of the relevant passages | Relevant to claim No. |
|---|---|---|
| X | CN 108288635 A (SAMSUNG DISPLAY CO., LTD.) 17 July 2018 (2018-07-17)<br>   description paragraphs [0076]-[0096], [0108]-[0121], [0134]-[0195], [0209]-[0213],<br>   figures 2-9E | 1-20 |
| X | CN 106448542 A (XIAMEN TIANMA MICROELECTRONICS CO., LTD. et al.) 22<br>February 2017 (2017-02-22)<br>   description, paragraphs [0032]-[0071], and figures 1-6 | 1-20 |
| A | CN 106324924 A (BOE TECHNOLOGY GROUP CO., LTD. et al.) 11 January 2017<br>(2017-01-11)<br>   entire document | 1-20 |

☐ Further documents are listed in the continuation of Box C.          ☑ See patent family annex.

| | |
|---|---|
| *    Special categories of cited documents: | "T"    later document published after the international filing date or priority date and not in conflict with the application but cited to understand the principle or theory underlying the invention |
| "A"    document defining the general state of the art which is not considered to be of particular relevance | |
| "E"    earlier application or patent but published on or after the international filing date | "X"    document of particular relevance; the claimed invention cannot be considered novel or cannot be considered to involve an inventive step when the document is taken alone |
| "L"    document which may throw doubts on priority claim(s) or which is cited to establish the publication date of another citation or other special reason (as specified) | "Y"    document of particular relevance; the claimed invention cannot be considered to involve an inventive step when the document is combined with one or more other such documents, such combination being obvious to a person skilled in the art |
| "O"    document referring to an oral disclosure, use, exhibition or other means | |
| "P"    document published prior to the international filing date but later than the priority date claimed | "&"    document member of the same patent family |

| Date of the actual completion of the international search | Date of mailing of the international search report |
|---|---|
| **24 December 2020** | **18 January 2021** |

| Name and mailing address of the ISA/CN | Authorized officer |
|---|---|
| **China National Intellectual Property Administration (ISA/CN)**<br>**No. 6, Xitucheng Road, Jimenqiao, Haidian District, Beijing 100088**<br>**China** | |
| Facsimile No. **(86-10)62019451** | Telephone No. |

Form PCT/ISA/210 (second sheet) (January 2015)

**INTERNATIONAL SEARCH REPORT**
Information on patent family members

| | International application No. |
|---|---|
| | **PCT/CN2020/083810** |

| Patent document cited in search report | | | Publication date (day/month/year) | Patent family member(s) | | | Publication date (day/month/year) |
|---|---|---|---|---|---|---|---|
| CN | 108288635 | A | 17 July 2018 | KR | 20180082688 | A | 19 July 2018 |
| | | | | US | 2020013848 | A1 | 09 January 2020 |
| | | | | US | 2018197484 | A1 | 12 July 2018 |
| | | | | US | 10446635 | B2 | 15 October 2019 |
| CN | 106448542 | A | 22 February 2017 | None | | | |
| CN | 106324924 | A | 11 January 2017 | CN | 106324924 | B | 02 August 2019 |
| | | | | US | 2018299984 | A1 | 18 October 2018 |
| | | | | WO | 2018072440 | A1 | 26 April 2018 |

Form PCT/ISA/210 (patent family annex) (January 2015)